# EUROPEAN PATENT SPECIFICATION

(11) **EP 0 845 051 B1**
(45) Date of publication and mention of the grant of the patent: **25.09.2002**
(21) Application number: 96927763.1
(22) Date of filing: 12.08.1996
(51) Int. Cl.: C23C 14/00

(54) **PREPARATION OF STRUCTURAL MATERIALS BY PHYSICAL VAPOUR DEPOSITION PROCESS**
VERFAHREN ZUR HERSTELLUNG VON KONSTRUKTIONSWERKSTOFFE DURCH PVD
PREPARATION DE MATERIAUX STRUCTURAUX PAR DEPOT SOUS VIDE PAR PROCEDE PHYSIQUE

(30) Priority: 18.08.1995 GB 9516927
(43) Date of publication of application: 03.06.1998
(73) Proprietor: Qinetiq Limited, London, SW1E 6PD (GB)
(72) Inventor: WARD-CLOSE, Charles, Malcolm, Farnborough, Hampshire GU14 0LX (GB); DUNFORD, David, Victor, Farnborough, Hampshire GU14 0LX (GB)
(86) International application number: GB9601966
(87) International publication number: WO97007257

(56) References cited:
- GB-A- 1 206 586
- METALLURGICAL AND MATERIALS TRANSACTIONS B: PROCESS METALLURGY AN D MATERIALS PROCESSING SCIENCE, vol. 26-B, no. 3, 1 June 1995, pages 603-610, XP000512535 DYER T S ET AL: "THE SYNTHESIS OF NICKEL ALUMINIDES BY MULTILAYER SELF-PROPAGATING COMBUSTION"
- JAPANESE JOURNAL OF APPLIED PHYSICS, PART 2 (LETTERS), AUG. 1988, JAPAN, vol. 27, no. 8, ISSN 0021-4922, pages L1530-L1532, XP002018842 KOBAYASHI T ET AL: "Improvement in soft magnetic properties of heat-treated Fe-C/Ni-Fe multilayers"

## Description

The present invention relates to structural materials and, in particular, to a process for the preparation of structural materials having a controlled microstructure and composition. The process uses the technique of physical vapour deposition onto a temperature-controlled collector for a sufficiently long period and at a sufficiently high vapour flux to deposit a bulk material of 0.5mm thickness or greater.

Methods and apparatus for the production of bulk alloys by physical vapour deposition have been described previously in British Patent Nos. 1 206 586 and 1 265 965. In the first of these patents, the basic principles were established for deposition of bulk alloys from the vapour phase, whereby the operation is carried out under vacuum inside a vacuum chamber and the alloy constituents are evaporated from one or more evaporation baths before being caused to condense on a temperature-controlled collector. In the second patent, an improved process is described in which inhomogeneity in the deposited alloy is minimised by moving the collector relative to the evaporation sources. Also, this patent addresses the problem of columnar growth in the deposit by proposing deposition of alternate layers of a first metal with thin layers of a second metal. In this way, each metal must nucleate and begin growth afresh with the deposition of successive layers. By suitable control of the process variables, it is possible to eliminate columnar growth.

In British Patent No. 2 264 952 B, an apparatus and method are disclosed for the preparation of alloys, the constituent metals of which have widely disparate vapour pressures, such as magnesium/transition metal element alloys.

There is continuing interest in the preparation of new materials using rapid solidification rate (hereafter referred to as RSR) production processes. Rapid solidification techniques including physical vapour deposition provide the means to overcome equilibrium thermodynamic constraints and to achieve compositions which are beyond the scope of conventional ingot metallurgy. This is achieved by effectively "freezing" constituent atoms in position before they have the opportunity to migrate and segregate as they would in conventional ingot processes. RSR techniques therefore offer a possible route to materials which cannot be obtained by other methods.

In the preparation of alloys as described above, physical vapour deposition is preferred over other forms of RSR processing for a number of reasons. Firstly, the cooling rate is much higher in physical vapour deposition and therefore the likelihood of formation of solid solutions is increased.

Secondly, physical vapour deposition offers a considerable choice of potential constituents since the candidate elements or compounds are raised to the vapour phase, in which state miscibility is ensured. By contrast, other forms of RSR processing are limited in the possible combinations of constituents to those substances which are miscible in the molten state. This is a particularly Important consideration in instances where one of the constituents has a very much higher vapour pressure than the other constituent or constituents of the proposed material.

Article "The synthesis of nickel aluminides by multi-layer self-propagating combustion" (Metallurgical and materials transactions B: Process Metallurgy and Materials Processing Science, vol. 26-B, no. 3, 1 June 1995, pages 603-610, Dyer T S et al.) discloses a method of synthesis of Ni-Al thin films wherein the films are deposited by electron beam evaporation onto a rotating holder, the individual thicknesses of the films ranging from about 100 to 500 nm, and the laminate removed from the holder and heated whereby the intermetallics NiAl and Ni₃AL are formed.

It is an object of the present invention to provide a structural material in which the composition and microstructure are precisely controlled. The advantages of achieving the degree of control which the present invention attains are that structural materials can be designed with enhanced mechanical properties, particularly increased fracture resistance and toughness.

It is a further object of the invention to provide a structural material having a refined grain size distribution which enables superplastic forming to be carried out at reduced temperatures compared to materials prepared by conventional ingot processes. Thus, materials prepared according to the present invention are particularly suited to the production of near net shape structures and provide the opportunity, during subsequent heat treatment, to develop the required microstructure in formed products for enhanced creep resistance and/or fracture toughness.

The invention is a process for producing a structural material having a controlled composition and microstructure, the process comprising the steps of:
(a) using a physical vapour deposition technique to deposit onto a temperature-controlled collector discrete layers of at least two materials in a known sequence, the layers being of predetermined relative thicknesses;
(b) removing the deposited layered material obtained in step (a) from the collector, and
(c) heating the layered material to a predetermined temperature effective to produce a compound, the composition of which is determined by the relative proportions of the materials deposited in step (a).
wherein barrier layers are interposed at intervals during the deposition step (a) for the purpose of preventing diffusion across the bulk deposit during the heat treatment step (c).

The microstructure of the bulk material can be controlled by interposing barrier layers at intervals during the deposition step for the purpose of preventing diffusion across the bulk deposit during heat treatment step. In a two-component system, for example, the provision of a barrier layer between adjacent bilayer pairs means that diffusion distances are short. In any event, diffusion is very rapid during the heat treatment step because of the high number of grain boundaries resulting from deposition on an atomic scale. Barrier layers aid suppression of grain enlargement by prevention of grain growth in one dimension, i.e. along the deposition axis.

Thus, the as-deposited microstructures can be preserved. Barrier layers of oxides such as yttria (Y₂O₃) are particularly well suited for this purpose and may be deposited using physical vapour deposition techniques or other suitable methods such as molecular beam epitaxy (MBE) or sputtering.

Preferably, the materials which are physically vapour deposited in the process of the present invention are metallic elements, so that the heat treatment step (c) is effective to produce an intermetallic compound of predetermined composition. The composition of this intermetallic compound can be controlled by varying the relative thicknesses of the deposited layers up to a maximum of about 150nm. This is also influential upon the microstructure for reasons which are explained in more detail below.

Alternatively, one of the vapour deposited materials may be a ceramic. In yet another form of the invention, the deposited materials may both be compounds such as oxides or nitrides to give a complex end product such as a mixed oxynitride.

Physical vapour deposition is a "line-of-sight" technique and therefore the thickness of respective layers of deposited materials is dependent on the dwell time of the collector in the respective vapour flux. In order to achieve the desired laminar precursor material in step (a), it is therefore necessary to expose the collector selectively to the respective vapour streams. This may be achieved by controlled shuttering of the collector or by moving the collector relative to the evaporation sources. Most conveniently, a rotating collector is used.

It is also possible to vary the rate of deposition of individual constituents by controlling the energy input to the respective evaporation sources.

Typically, the thicknesses of deposited layers range from 5 Å to 50 nm. Preferably, the layers range in thickness from 1 nm to 40 nm, most preferably from 2.5 nm to 20 nm.

As indicated above, by using layer thicknesses in the nanoscale range, grain sizes are maintained at a minimum. This means that there is a high number of grain boundaries in any given deposited layer and diffusion during the subsequent heat treatment step is very rapid. In addition, the favourable circumstances for diffusion mean that it can be carried out in the solid state at a temperature very much lower than the melt temperatures of the constituent starting materials or of the compound which they form.

The invention will now be described by way of example only with reference to the single figure which is a schematic representaion of a multi-source vapour deposition apparatus.

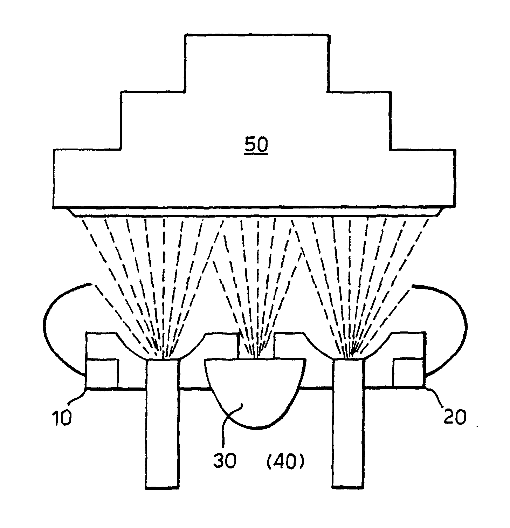

In Figure 1, a vapour deposition laminating facility is shown which, in use, is enclosed in a high vacuum system (10 - 7 mbar). Vacuum pumping is provided by a cryogenic pump (high vacuum) and rotary pump.

The evaporation station comprises a pair of 14 kw electron beam guns 10, 20 and a pair of thermal evaporation sources 30,40 (only one shown) which are positioned beneath a rotatable aluminium collector 50. The rotatable collector 50 is water cooled, but control of deposition microstructure and adhesion of the deposit to the collector surface is provided by heating the collector surface with 8 kw lamps (not shown). Accurate control of deposited layer thicknesses is achieved by rotating the collector at speeds from 0.01 to 4,000 revolutions per minute and by controlling the power to the evaporation sources. Uniform speed control of the rotatable collector 50 may be achieved using a proportional controller and a gear box, especially for low speeds. Visual observation of the evaporation and deposition steps may be provided by means of viewing ports positioned around the vacuum chamber.

Prior to commencement of deposition, the receiving surface of the rotatable collector 50 is prepared by shot blasting to give a roughen surface. Alternatively, the roughen surface can be obtained by plastic media blasting or, if desired, a smooth surface can be obtained by polishing to a diamond finish.

Initially, the evaporation sources are controlled to give an initial thick layer of aluminium deposit to provide a key for subsequent laminated layers.

Subsequently, alternating layers of titanium and aluminium having thicknesses of 1 - 2 nm are deposited onto the collector 50 which is held at a mean temperature of 300°C. After a period of about 2 hours, a thin sheet approximately 0.5 mm is deposited.

After release of the vacuum and dismantling of the evaporation apparatus, the deposited laminate is removed from the collector. If necessary, the deposited laminate can be machined from the collector.

Subsequent thermal treatment at temperatures in the range of 400 - 600°C of samples prepared using the above procedure produced complete titanium aluminides and resulted in total removal of the layered structure. By tailoring the layer thickness of each constituent, it is possible to control the composition of the intermetallic compound. For example, 5 nm aluminium layers alternated with 15 nm titanium layers gave a Ti₃Al compound whilst equal thickness layers of 5 nm aluminium and 5 nm titanium gave the TiAl compound.

As mentioned above, it is possible to control the actual thickness of the developed intermetallic by incorporating intermediate barrier layers such as yttria.

Although the process of the present invention has been described above with reference to titanium aluminides, other intermetallic systems such as Fe/Al, Ni/Al and Mo/Si may be produced in process by this method. Other systems will suggest themselves to persons skilled in the art.

Also, it should be recognised that the process according to the present invention is not limited to metal/metal systems but may be extended to include metal/ceramic systems and other combinations of structural materials.

## Claims

1. A process for producing a structural material having a controlled composition and microstructure, the process comprising the steps of:
(a) using a physical vapour deposition technique to deposit onto a temperature-controlled collector discrete layers of at least two materials in a known sequence, the layers being of predetermined relative thicknesses of up to 150nm;
(b) removing the deposited layered material obtained in step (a) from the collector, and
(c) heating the layered material to a predetermined temperature effective to produce a compound, the composition of which is determined by the relative proportions of the materials deposited in step (a),
wherein barrier layers are interposed at intervals during the deposition step (a) for the purpose of preventing diffusion across the bulk deposit during the heat treatment step (c).

2. A process as claimed in claim 1 wherein the materials which are physically vapour deposited in step (a) are metallic elements.

3. A process as claimed in claim 1 wherein at least one of the materials physically vapour deposited in step(a) is a ceramic.

4. A process as claimed in any preceding claim wherein the deposition is carried out onto a rotating collector.

5. A process as claimed in any preceding claim wherein the thicknesses of deposited layers range from 5 Å to 50 nm.

6. A process as claimed in claim 5 wherein the thicknesses of deposited layers range from 1 nm to 40 nm.

7. A process as claimed in claim 6 wherein the thicknesses of deposited layers range from 2.5 nm to 20 nm.

8. A process as claimed in any preceding claim wherein the heat treatment step (c) includes a solid state diffusion step.

## Patentansprüche

1. Verfahren zum Erzeugen eines Strukturmaterials mit kontrollierter Zusammensetzung und Mikrostruktur, wobei das Verfahren die folgenden Schritte umfaßt:
(a) Verwenden einer Technik der physikalischen Dampfabscheidung, um auf einem temperaturgesteuerten Kollektor diskrete Schichten aus wenigstens zwei Materialien in einer bekannten Reihenfolge abzuscheiden, wobei die Schichten vorgegebene relative Dicken bis zu 150 nm besitzen;
(b) Entfernen des abgeschiedenen Schichtmaterials, das im Schritt (a) erhalten wird, vom Kollektor und
(c) Erwärmen des Schichtmaterials auf eine vorgegebene Temperatur, die bewirkt, daß eine Verbindung erzeugt wird, deren Zusammensetzung durch die relativen Verhältnisse der im Schritt (a) abgeschiedenen Materialien bestimmt ist,
wobei während des Abscheidungsschrittes (a) dazwischen Sperrschichten in Intervallen eingefügt werden, um eine Diffusion durch die Massenabscheidung während des Wärmebehandlungsschrittes (c) zu verhindern.

2. Verfahren nach Anspruch 1, bei dem die Materialien, die im Schritt (a) durch physikalische Dampfabscheidung abgeschieden werden, metallische Elemente sind.

3. Verfahren nach Anspruch 1, bei dem wenigstens eines der Materialien, das im Schritt (a) durch physikalische Dampfabscheidung abgeschieden wird, eine Keramik ist.

4. Verfahren nach einem vorhergehenden Anspruch, bei dem die Abscheidung auf einem rotierenden Kollektor ausgeführt wird.

5. Verfahren nach einem vorhergehenden Anspruch, bei dem die Dicken der abgeschiedenen Schichten im Bereich von 5 Å bis 50 nm liegen.

6. Verfahren nach Anspruch 5, bei dem die Dicken der abgeschiedenen Schichten im Bereich von 1 nm bis 40 nm liegen.

7. Verfahren nach Anspruch 6, bei dem die Dicken der abgeschiedenen Schichten im Bereich von 2,5 nm bis 20 nm liegen.

8. Verfahren nach einem vorhergehenden Anspruch, bei dem der Wärmebehandlungsschritt (c) einen Festkörperdiffusionsschritt umfaßt.

## Revendications

1. Procédé pour produire un matériau de structure ayant une composition et une microstructure commandées, le procédé comportant les étapes consistant à :
(a) utiliser une technique de dépôt en phase gazeuse par procédé chimique pour déposer sur un collecteur commandé en température des couches séparées d'au moins deux matériaux dans une séquence connue, les couches ayant des épaisseurs relatives prédéterminées allant jusqu'à 150nm,
(b) enlever le matériau en couche déposé obtenu à l'étape (a) à partir du collecteur, et
(c) chauffer le matériau en couche à une température prédéterminée efficace pour produire un composé, dont la composition est déterminée par les proportions relatives des matériaux déposés à l'étape (a),
dans lequel des couches de barrière sont interposées à des intervalles pendant l'étape de dépôt (a) dans le but d'empêcher une diffusion à travers le dépôt en vrac pendant l'étape de traitement thermique (c).

2. Procédé selon la revendication 1, dans lequel les matériaux qui sont déposés en phase gazeuse par procédé physique à l'étape (a) sont des éléments métalliques.

3. Procédé selon la revendication 1, dans lequel au moins un des matériaux déposés en phase gazeuse par procédé physique à l'étape (a) est une céramique.

4. Procédé selon l'une quelconque des revendications précédentes dans lequel le dépôt est effectué sur un collecteur rotatif.

5. Procédé selon l'une quelconque des revendications précédentes, dans lequel les épaisseurs des couches déposées sont situées dans une plage allant de 5 Å à 50 nm.

6. Procédé selon la revendication 5, dans lequel les épaisseurs des couches déposées sont situées dans une plage allant de 1 nm à 40 nm.

7. Procédé selon la revendication 6, dans lequel les épaisseurs des couches déposées sont situées dans une plage allant de 2,5 nm à 20 nm.

8. Procédé selon l'une quelconque des revendications précédentes, dans lequel l'étape de traitement thermique (c) comporte une étape de diffusion à l'état solide.
